# EUROPÄISCHE PATENTSCHRIFT

(11) **EP 0 364 806 B1**
(45) Veröffentlichungstag und Bekanntmachung des Hinweises auf die Patenterteilung: **20.01.1993**
(21) Anmeldenummer: 89118295.8
(22) Anmeldetag: 03.10.1989
(51) Int. Cl.: H01L 25/075, H01L 25/13, H01L 33/00, F21M 1/00, F21Q 1/00

(54) **Flächenhafter Strahler**
Surface light-emitting device
Emetteur de lumière par surface

(30) Priorität: 21.10.1988 DE 3835942
(43) Veröffentlichungstag der Anmeldung: 25.04.1990
(73) Patentinhaber: TEMIC TELEFUNKEN microelectronic GmbH, 74072 Heilbronn (DE)
(72) Erfinder: Schairer, Werner, Dr., D-7102 Weinsberg (DE)
(74) Vertreter: Maute, Hans-Jürgen, Dipl.-Ing.

(56) Entgegenhaltungen:
- FR-A- 1 449 911
- FR-A- 1 543 748
- FR-A- 2 481 563
- FR-A- 2 518 317
- FR-A- 2 524 155
- PATENT ABSTRACTS OF JAPAN vol. 12, no. 174 (E-612)(3021) 24 Mai 1988;& JP-A-62281374

## Beschreibung

Die Erfindung betrifft einen flächenhaften Strahler nach dem Oberbegriff des Anspruchs 1.
In flächenhaften Strahlern, beispielsweise Kfz-Leuchten, werden in der Regel Glühlampen, meist zusammen mit einem Reflektor, eingesetzt. Glühlampen besitzen aber nur eine begrenzte Lebensdauer, zudem hat man, bedingt durch die Abmessungen der Birne, eine relativ große Bautiefe.

Lumineszenzdioden haben demgegenüber den Vorteil, daß sie eine größere Lebensdauer besitzen und daher zuverlässiger arbeiten, daß sie einen besseren elektro-optischen Wirkungsgrad und deshalb geringeren Energiebedarf aufweisen und daß wegen ihrer flachen Struktur kleinere Bautiefen möglich sind. Lumineszenzdioden werden daher bevorzugt dort eingesetzt, wo ein Austausch einzelner Lampen umständlich und teuer ist und wo hohe Anforderungen an die Zuverlässigkeit, Sicherheit und Langzeitstabilität des Strahlers gestellt werden.

Um einen Strahler mit hohem Wirkungsgrad und in flacher Bauweise herzustellen, wurde bereits vorgeschlagen, Lumineszenz-Halbleiterkörper, die jeweils von einem Gehäusekörper umgeben sind, in einer flächenhaften Verteilung auf einer ebenen Glasplatte zu montieren.

In vielen Anwendungsfällen, beispielsweise im Kfz-Bereich, besitzen die Strahler eine gekrümmte Form.

Die Glasplatte, auf der die Lumineszenz-Halbleiterkörper montiert werden, kann jedoch nicht in die gewünschte gekrümmte Form, beispielsweise durch Verbiegen, gebracht werden. Sie muß daher bereits bei der Herstellung eine gekrümmte Form besitzen; eine Montage der Halbleiterkörper auf einer gekrümmten Oberfläche ist jedoch mit großen Schwierigkeiten verbunden.

FR-A- 2518317 und FR-A- 2481563 offenbaren Lumineszenzdioden, die auf eines flexiblen, bzw. gekrümmten Unterlage montiert sind.

Der Erfindung liegt die Aufgabe zugrunde, einen Strahler anzugeben, bei dem eine einfache Montage der Halbleiterkörper möglich ist und der dennoch eine geforderte gekrümmte Form annehmen kann.
Dies wird erfindungsgemäß dadurch erreicht, daß die Leitbahnstruktur zwischen den einzelnen Gehäusekörpern derart beweglich ausgebildet ist, daß der Strahler in eine beliebig gekrümmte Form gebracht werden kann.

Weitere vorteilhafte Ausgestaltungen der Erfindung ergeben sich aus den Unteransprüchen.

Die Halbleiterkörper sind in einer den jeweiligen Bedürfnissen, z.B. geforderte Lichtstärke oder Krümmung des Strahlers, entsprechenden Anzahl auf der Leitbahnstruktur, vorzugsweise in einer gleichmäßigen Verteilung, angeordnet. Bei einer geforderten hohen Strahlungsleistung grenzen die Halbleiterkörper höchstens so dicht aneinander, daß die Beweglichkeit der Leitbahnstruktur nicht eingeschränkt wird.

Der Herstellungsprozeß des erfindungsgemäßen Strahlers und seine Ausführungsformen sollen nun anhand der Figuren 1 - 4 beschrieben werden. Es zeigen:
Figur 1 Eine Aufsicht auf die Leitbahnstruktur mit den Halbleiterkörpern.
Figur 2 Eine Schnittdarstellung des flächenhaften Strahlers, bei dem die Reflektoren als Vollform ausgebildet sind.
Figur 3 Eine Schnittdarstellung des flächenhaften Strahlers, bei dem die Reflektoren als Hohlform ausgebildet sind.
Figur 4 Eine Schnittdarstellung des flächenhaften Strahlers, bei dem die als Vollform ausgebildeten Reflektoren sowohl unterhalb als auch oberhalb der Leitbahnstruktur angeordnet sind.

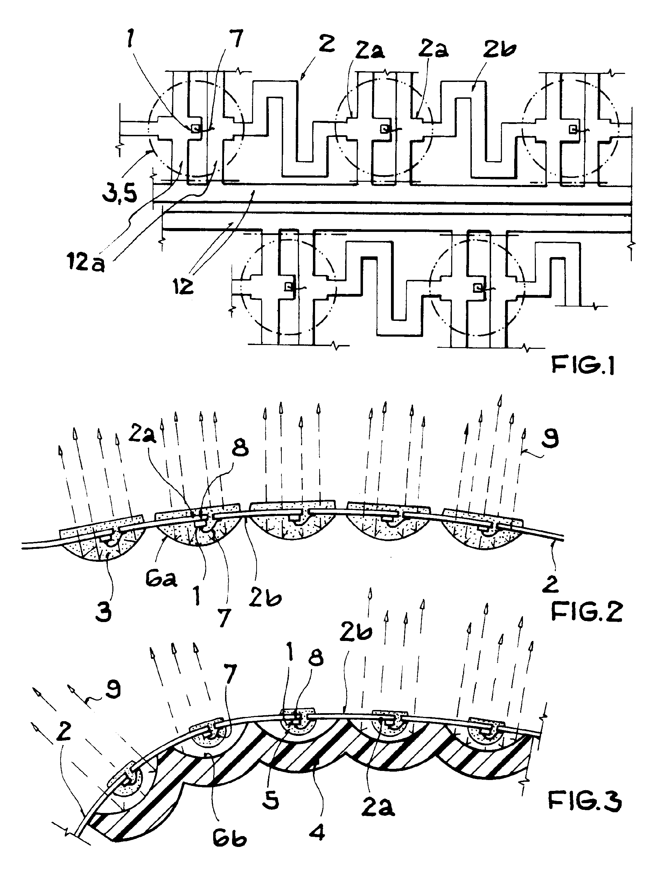

Das Herstellungsverfahren der Leitbahnstruktur und die Montage der Lumineszenz-Halbleiterkörper auf der planaren Leitbahnstruktur wird anhand der Figur 1 erläutert. Aus einem Blech oder einer Metallplatte werden Metallstreifen ausgestanzt, wobei durch eine bestimmte Formgebung erreicht wird, daß dehnbare Leitbahnstücke 2b sowie Hilfsverbindungen 12 vorhanden sind. Die Metallstreifen 2a, 2b werden speziell beschichtet, beispielsweise mit einer Nickel-Haftschicht und einer darüber liegenden Silberschicht und dienen als Leitbahnen zur Kontaktierung und Zusammenschaltung der Halbleiterkörper 1. Die Hilfsverbindungen 12 werden zur mechanischen Stabilisierung der Leitbahnstruktur 2 verwendet. Die Verbindungsstücke 12a von der Leitbahnstruktur 2 zu den Hilfsverbindungen 12 werden vorzugsweise außerhalb des Bereichs der Halbleiterkörper 3, 5, d.h. im beweglichen Teil 2b der Leitbahnstruktur angebracht, um eine optimale Strahlungsausnutzung zu gewährleisten.

Die Halbleiterkörper 1, die beispielsweise eine Ausdehnung von 250 µm x 250 µm besitzen, werden, vorzugsweise durch automatische Bestückung, auf den Teil 2a der planaren Leitbahnstruktur aufgeklebt oder aufgelötet und durch Bonddrähte 7 mit der nächsten Streifenposition, d.h. dem nächsten Leitbahnstück, verbunden. Beispielsweise werden diejenigen Stellen auf der Leitbahnstruktur, an denen die Halbleiterkörper 1 angebracht werden sollen, mit einem leitfähigen Kleber betropft. In diese Tropfen werden dann die Halbleiterkörper eingesetzt und der Kleber bei einer Temperatur von beispielsweise 150 °C ausgehärtet.

Anhand der Figur 2 wird ein Ausführungsbeispiel beschrieben, bei dem die Reflektoren als Vollform ausgebildet sind.
Die Leitbahnstruktur 2 mit den darauf befestigten und kontaktierten Halbleiterkörpern 1 wird nun derart auf eine vorzugsweise parabelförmige Gießform gelegt, daß sich die Halbleiterkörper 1 im Brennpunkt der Parabel und die beweglichen Teile 2b der Leitbahnstruktur zwischen den Aussparungen der Gießform befinden. Die Gießform besteht vorzugsweise aus einem Kunststoff-Material und kann mittels der Kunststoff-Spritzgußtechnik in der gewünschten Form hergestellt werden. Zur Herstellung der Reflektoren 6a wird die Gießform mit einer Kunststoff-Vergußmasse, beispielsweise Siliconharz, Epoxidharz, Polyimid oder Polyphenylensulfid ausgegossen. Jeder Halbleiterkörper 1 befindet sich somit im Brennpunkt des parabolischen Kunststoff-Gehäusekörpers 3. Nach dem Härten der Vergußmasse bei beispielsweise 150 °C und der Entformung durch die Entfernung der Gießform kann die Außenfläche des Kunststoffkörpers 3 zur Bildung der Reflektoren 6a mittels eines hochreflektierenden Materials, beispielsweise Aluminium oder Silber, beschichtet werden. Dabei ist darauf zu achten, daß die elektrischen Zuleitungen 2a nicht kurzgeschlossen werden.
Durch die parabolische Form der Reflektoren 6a wird die gesamte reflektierte Strahlung 9 parallel gebündelt, so daß man die größtmögliche Lichtstärke erhält.
Die Hilfsverbindungen 12 zur Stabilisierung der Leitbahnstruktur werden nun nicht mehr benötigt und durch Freischneiden entlang den strichpunktierten Linien in Figur 1 wieder entfernt. Anschließend wird der gesamte Strahler gegen eine Unterlage in die gewünschte, beispielsweise gekrümmte Form gedrückt. Durch die beweglichen Leitbahnstücke 2b, die sich zwischen den Gehäusekörpern 3 befinden, ist gewährleistet, daß der Strahler eine beliebige Form annehmen kann.
Die Unterlage kann dabei gleichzeitig als stabilisierende Rückwand dienen; der Strahler wird dann auf dieser Unterlage, beispielsweise durch Verkleben, fixiert. Falls die Gießform z.B. aus Stabilitätsgründen oder als Schutz für die reflektierenden Flächen benötigt wird, wird sie nach dem Aushärten der Vergußmasse nicht entfernt; sie muß dann allerdings bereits die gewünschte Form des Strahlers besitzen. Die Innenseite der Gießform ist dann hochreflektierend ausgebildet, wozu sie vor dem Einbringen der Vergußmasse beispielsweise mit einem hochreflektierenden Material beschichtet werden kann.
Die Kontaktfläche 8 auf der Rückseite des Halbleiterkörpers wird möglichst hochreflektierend ausgebildet, so daß die in Richtung Leitbahnstruktur emittierte Strahlung größtenteils reflektiert wird und zu der direkt in Richtung Reflektor emittierten und dort reflektierten Strahlung 9 und somit zur Gesamtemission beiträgt, woraus sich ein hoher Sammelwirkungsgrad ergibt.

In einer anderen Ausführungsform gemäß Figur 3, sind die Reflektoren 6b vermöge eines Formkörpers 4 als Hohlform ausgebildet.
Die Montage und Kontaktierung der Halbleiterkörper 1 auf der Leitbahnstruktur 2 wird genauso durchgeführt, wie dies anhand der Figur 1 beschrieben wurde. Um die Strahlungsauskopplung aus dem Lumineszenz-Halbleiterkörper 1 zu verbessern, werden die Halbleiterkörper mit einem Kunstharz, der einen Brechungsindex von beispielsweise 1,5 besitzt, betropft, so daß die Halbleiterkörper 1 in einem Gehäusekörper 5 eingebettet sind. Die Leitbahnstruktur 2 mit den Halbleiterkörpern 1 wird nach dem Entfernen der Hilfsverbindungen 12 auf den Formkörper 4 gelegt, der bereits die gewünschte Form des Strahlers besitzen muß, und beispielsweise als Gehäuserückwand dienen kann. Die Leitbahnstruktur 2 wird ohne Vergießen mit dem Formkörper 4 verbunden, beispielsweise durch Kleben an bestimmten Stellen der Leitbahnen. Die Innenseite des Formkörpers ist hochreflektierend und kann beispielsweise vor dem Zusammenschluß mit der Leitbahnstruktur mit einem hochreflektierenden Material beschichtet werden. Auch hier wird überwiegend nur die mittels des Reflektors 6b reflektierte Strahlung 9 ausgekoppelt.

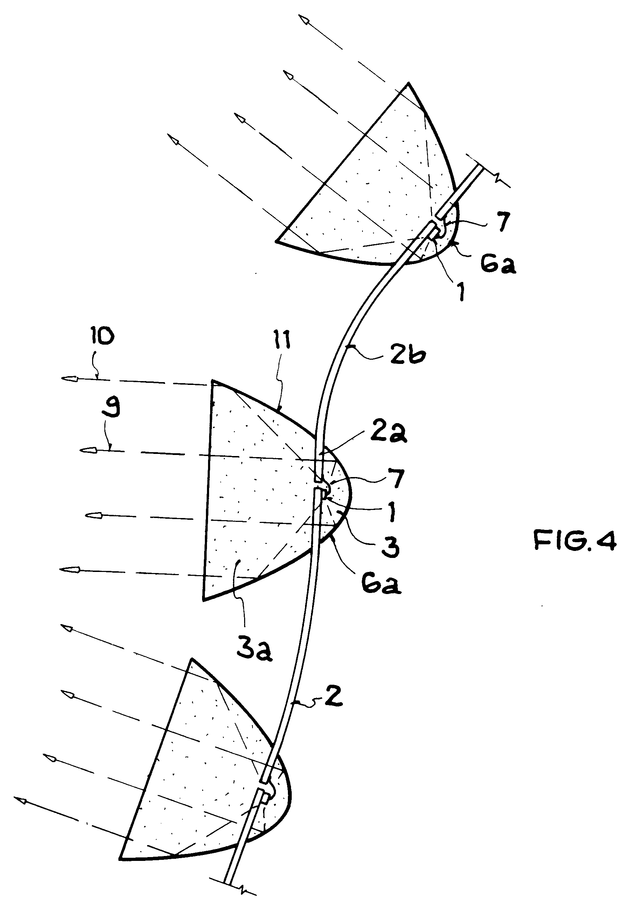

Bei einer weiteren, in Figur 4 dargestellten Ausführungsform, wird zunächst ein Strahler gemäß Figur 2 als Vollform ausgebildet und anschließend weitere Kunststoffkörper 3a, die mittels separater Gießformen oder Spritzformen hergestellt werden können, beispielsweise vermöge eines optischen Klebers auf der Oberseite der Leitbahnstruktur angebracht. Diese zusätzlichen Kunststoffkörper 3a besitzen die Form eines Parabelstumpfs und werden so auf die Oberseite der Leitbahnstruktur geklebt, daß die Gehäusekörper 3, 3a unterhalb und oberhalb der Leitbahnstruktur 2 zusammen ein parabolisches Profil ergeben. Die Außenflächen der Kunststoffkörper 3a werden zur Bildung von Reflektoren 11 mittels eines hochreflektierenden Materials beschichtet. Bei dieser Ausführungsform wird sowohl ein Großteil der zur Leitbahnstruktur hin emittierten Strahlung 10 durch die Reflektoren 11 als auch die an den Reflektoren 6a reflektierte Strahlung 9 gebündelt, so daß die Lichtstärke und der Lichtnutzungsgrad ansteigt.
Die Kunststoffkörper 3a der Reflektoren 11 oberhalb der Leitbahnstruktur bestehen vorzugsweise aus dem gleichen Material wie die Kunststoffkörper 3 der Reflektoren 6a unterhalb der Leitbahnstruktur.

Die Kontaktierung und Verdrahtung der Halbleiterkörper 1 gemäß der Figur 1 richtet sich nach der Spezifikation des Strahlers. Die Halbleiterkörper 1 können auf der gesamten zu Verfügung stehenden Fläche angebracht und zur Erhöhung der Betriebsspannung hintereinandergeschaltet und/oder zur Erzielung der notwendigen Lichtstärke parallelgeschaltet werden. Diese Zusammenschaltung ist dabei gemäß des vorgegebenen Layouts der Leitbahnstruktur 2 beliebig variierbar.
Vorzugsweise werden die Halbleiterkörper 1 derart auf der Leitbahnstruktur 2 angeordnet, daß für bestimmte Anforderungen eine maximale Lichtstärke erzielt wird. Dazu können beispielsweise die Gehäusekörper 3, 5 so dicht aneinandergrenzen, daß einerseits der auf der Leitbahnstruktur zur Verfügung stehende Platz optimal ausgenutzt wird ohne daß aber dabei andererseits die Beweglichkeit der Leitbahnstruktur zu sehr eingeschränkt wird.

Die Form des Strahlers, die Zahl der verwendeten Lumineszenzdioden, deren Verschaltung sowie die Wellenlänge der emittierten Strahlung kann dabei exakt nach den spezifischen Anforderungen vorgegeben werden, wobei der Spektralbereich der emittierten Strahlung ohne weiteres auch in den infraroten Bereich, z. B. durch Bestückung mit GaAs-Dioden, verschoben werden kann.

Die verwendeten Lumineszenzdioden besitzen typischerweise eine Flußspannung von 2 V und eine zulässige Stromstärke von 50 mA, so daß beispielsweise für eine Betriebsspannung von 12 V ca. 5 - 6 Dioden hintereinander geschaltet werden müssen.
Der Lichtstrom einer Einzel-Lumineszenzdiode beträgt typischerweise 1 - 4 lm, die Lichtstärke ca. 1 - 3 cd; für eine Kfz-Bremsleuchte beispielsweise muß die Lichtstärke zwischen 40 cd und 100 cd liegen.
Um beispielsweise Rotlicht-emittierende Strahler zu erhalten, können GaAlAs-Heterostrukturdioden eingesetzt werden, deren maximale Emission bei 660 nm liegt. Der erfindungsgemäße Strahler ist vielfältig einsetzbar; denkbar ist beispielsweise die Verwendung als Kfz-Leuchte, Signalleuchte oder Begrenzungsleuchte.

## Patentansprüche

1. Flächenhafter Strahler, bei dem flächenhaft verteilte Lumineszenz-Halbleiterkörper (1) durch eine Leitbahnstruktur (2) miteinander verbunden und die einzelnen Lumineszenz-Halbleiterkörper (1 ) von Gehäusekörpern (3, 5) umgeben sind, dadurch gekennzeichnet, daß die Leitbahnstruktur (2b) zwischen den einzelnen Gehäusekörpern Selbsttragend und (3, 5) derart beweglich ausgebildet ist, daß der Strahler in eine beliebig gekrümmte Form gebracht werden kann.

2. Flächenhafter Strahler nach Anspruch 1, dadurch gekennzeichnet, daß die Gehäusekörper (3, 5) von Reflektoren (6a, 6b) umgeben sind.

3. Flächenhafter Strahler nach Anspruch 1 und 2, dadurch gekennzeichnet, daß die Reflektoren (6a, 6b) parabolisch geformt sind, und daß die Leitbahnstruktur (2) mit den Halbleiterkörpern (1) derart angeordnet ist, daß jeweils ein Halbleiterkörper (1) im Bereich des Brennpunkts eines Reflektors (6a, 6b) liegt.

4. Flächenhafter Strahler nach Anspruch 1 bis 3, dadurch gekennzeichnet, daß jeder Halbleiterkörper (1) in einem Kunststoff-Gehäusekörper (3) eingebettet ist, und daß die Außenflächen der Kunststoff-Gehäusekörper (3) als Reflektoren (6a) ausgebildet sind.

5. Flächenhafter Strahler nach Anspruch 1 bis 3, dadurch gekennzeichnet, daß jeder Halbleiterkörper (1) in einem Kunstsoff-Gehaüsekörper (3) eingebettet ist, und daß die Kunststoff-Gehäusekörper (3) von einer Gießform umgeben sind, deren Innenseite die Reflektoren bildet.

6. Flächenhafter Strahler nach Anspruch 1 bis 3, dadurch gekennzeichnet, daß jeder Halbleiterkörper (1) in einem Kunststoff-Gehäusekörper (3) eingebettet ist, und daß die Halbleiterkörper (1) von einem Formkörper (4) umgeben sind, dessen Innenseite die Reflektoren (6b) bildet und daß sich zwischen Kunststoff-Gehäusekörper (5) und Formkörper (4) Luft befindet.

7. Flächenhafter Strahler nach einem der vorangehenden Ansprüche, dadurch gekennzeichnet, daß an der Oberseite der Leitbahnstruktur zusätzliche Reflektoren (11) angebracht sind, die als Parabelstumpf ausgebildet sind und zusammen mit den Reflektoren (6a, 6b) an der Unterseite der Leitbahnstruktur die Form eines Paraboloids besitzen.

8. Flächenhafter Strahler nach Anspruch 7, dadurch gekennzeichnet, daß die zusätzlichen Reflektoren (11) an der Oberseite der Leitbahnstruktur als Kunststoffkörper (3a), deren Außenflächen hochreflektieren, ausgebildet sind.

9. Flächenhafter Strahler nach einem der vorangehenden Ansprüche, dadurch gekennzeichnet, daß die Halbleiterkörper (1) mittels der Leitbahnstruktur (2) parallelund/oder hintereinandergeschaltet werden.

10. Verwendung eines flächenhaften Strahlers nach einem der vorangehenden Ansprüche für Kfz-Leuchten, Signalleuchten oder Begrenzungsleuchten.

11. Verfahren zur Herstellung eines flächenhaften Strahlers nach einem der Ansprüche 1 bis 9, dadurch gekennzeichnet, daß die Halbleiterkörper (1) auf einer selbsttragenden und durch Hilfsverbindungen (12) stabilisierten Leitbahnstruktur (2) kontaktiert werden, und daß die Halbleiterkörper (1) mit Hilfe einer Gießform zur Bildung von Gehäusekörpern (3) vergossen werden, daß nach dem Entfernen der Gießform die Außenflächen der Gehäusekörper (3) mit einem hochreflektierenden Material beschichtet werden, daß anschließend die Hilfsverbindungen (12) durch Freischneiden entfernt werden und daß durch Verbiegen der Leitbahnstruktur (2b) zwischen den Gehäusekörpern diese mit einer gewünschten bestimmten Wölbung versehen wird.

12. Verfahren nach Anspruch 11, dadurch gekennzeichnet, daß die Innenflächen der Gießform, die eine gewünschte bestimmte Wölbung besitzt, mit einem hochreflektierenden Material beschichtet werden, daß die Halbleiterkörper (1) in dieser Gießform vergossen werden und daß die Hilfsverbindungen (12) durch Freischneiden entfernt werden.

13. Verfahren nach Anspruch 11, dadurch gekennzeichnet, daß die Halbleiterkörper (1) mit einem Kunststoff-Material betropft werden, daß die Innenfläche eines Formkörpers (4), der eine gewünschte bestimmte Wölbung besitzt, mit einem hochreflektierenden Material beschichtet wird, daß die Leitbahnstruktur (2) mit den Halbleiterkörpern (1) auf den Formkörper (4) gelegt wird und nach dem Freischneiden der Hilfsverbindungen (12) mit dem Formkörper (4) verklebt wird.

14. Verfahren nach Anspruch 11, dadurch gekennzeichnet, daß an der Oberseite der Leitbahnsbuktur zusätzliche Gehäusekörper (3a) angebracht werden und daß deren Außenflächen metallisch beschichtet werden.

## Claims

1. Surface emitter in which luminescent semiconductor bodies (1) distributed over an area are connected with one another via a conductive track structure (2) and the individual luminescent semiconductor bodies (1) are surrounded by housing bodies (3, 5), characterised in that, the conductive track structure (2) between the individual housing bodies (3, 5) is constructed to be self-supporting and flexible to such an extent that the emitter can be formed into any curved shape.

2. Surface emitter in accordance with Claim 1, characterised in that, the housing bodies (3, 5) are surrounded by reflectors (6a, 6b).

3. Surface emitter in accordance with Claim 1 and 2, characterised in that, the reflectors (6a, 6b) are parabolically shaped, and that the conductive track structure (2) with the semiconductor bodies (1) is arranged in such a way that each semiconductor body (1) lies in the region of the focal point of a respective reflector (6a, 6b).

4. Surface emitter in accordance with Claim 1 to 3, characterised in that, each semiconductor body (1) is embedded in a housing body (3) of synthetic material, and that the outer surfaces of the housing bodies (3) of synthetic material are constructed as reflectors (6a).

5. Surface emitter in accordance with Claim 1 to 3, characterised in that, each semiconductor body (1) is embedded in a housing body (3) of synthetic material, and that the housing bodies (3) of synthetic material are surrounded by a mould whose inner surface forms the reflectors.

6. Surface emitter in accordance with Claim 1 to 3, characterised in that, each semiconductor body (1) is embedded in a housing body (3) of synthetic material, and that the semiconductor bodies (1) are surrounded by a shaped body (4) whose inner surface forms the reflectors (6a, 6b), and that air is contained between the housing bodies (5) of synthetic material and the shaped body (4).

7. Surface emitter in accordance with any of the preceding Claims, characterised in that, additional reflectors (11) are positioned on the upper surface of the conductive track structure which are constructed as frusta of a parabola and which, together with the reflectors (6a, 6b) on the lower surface of the conductive track structure have the shape of a parabaloid.

8. Surface emitter in accordance with Claim 7, characterised in that, the additional reflectors (11) on the upper surface of the conductive track structure are constructed as bodies (3a) of synthetic material whose outer surfaces are highly reflecting.

9. Surface emitter in accordance with any of the preceding Claims, characterised in that, the semiconductor bodies (1) are connected in series and/or parallel by means of the conductive track structure (2).

10. Use of a surface emitter in accordance with any of the preceding Claims for motor vehicle lights, signal lights or side lights.

11. Method for the manufacture of a surface emitter in accordance with any of the Claims 1 to 9, characterised in that, the semiconductor bodies (1) are contacted to a self supporting conductive track structure (2) which is stabilised by auxiliary connections (12), and that the semiconductor bodies (1) are potted with the aid of a mould for the formation of housing bodies (3), that the outer surfaces of the housing bodies (3) are coated with a highly reflecting material after the removal of the mould, that thereafter the auxiliary connections (12) are removed by cutting them free, and that, by bending the conductive track structure (2b) between the housing bodies, this is provided with a certain desired curvature.

12. Method in accordance with Claim 11, characterised in that, the inner surfaces of the mould which has a certain desired curvature are coated with a highly reflecting material, that the semiconductor bodies (1) are potted in this mould, and that the auxiliary connections (12) are removed by cutting them free.

13. Method in accordance with Claim 11, characterised in that, the semiconductor bodies (1) are beaded with a synthetic material, that the inner surface of a shaped body (4) which has a certain desired curvature is coated with a highly reflecting material, that the conductive track structure (2) with the semiconductor bodies (1) is placed on the shaped body (4) and, after the cutting free of the auxiliary connections (12), is cemented to the shaped body (4).

14. Method in accordance with Claim 11, characterised in that, additional housing bodies (3a) are provided on the upper surface of the conductive track structure and that their outer surfaces are metallically coated.

## Revendications

1. Emetteur de lumière à effet de surface, dans le cas duquel des corps semi-conducteurs luminescents (1), répartis sur une surface, sont réunis les uns aux autres au moyen d'une structure de rubans conducteurs (2) et dans le cas duquel les différents corps semi-conducteurs luminescents (1) sont entourés de corps enveloppes (3,5), émetteur caractérisé par le fait que la structure de rubans conducteurs (2b) entre les différents corps enveloppes (3,5) est conçue autoportante et mobile de façon que l'émetteur de lumière puisse être amené en une forme courbe quelconque.

2. Emetteur de lumière à effet de surface selon la revendication 1, caractérisé par le fait que les corps enveloppes (3,5) sont entourés par des réflecteurs (6a,6b).

3. Emetteur de lumière à effet de surface selon les revendications 1 et 2, caractérisé par le fait que les réflecteurs (6a,6b) sont de forme parabolique et par le fait que la structure de rubans conducteurs (2) avec les corps semi-conducteurs (1) est disposée de façon qu'un corps semi-conducteur (1) se trouve chaque fois dans la zone du foyer d'un réflecteur (6a,6b).

4. Emetteur de lumière à effet de surface selon les revendications 1 à 3, caractérisé par le fait que chaque corps semi-conducteur (1) est enrobé dans un corps enveloppe plastique (3) et par le fait que les surfaces extérieures des corps enveloppes plastiques (3) sont conçues comme servant de réflecteurs (6a).

5. Emetteur de lumière à effet de surface selon les revendications 1 à 3, caractérisé par le fait que chaque corps semi-conducteur (1) est enrobé dans un corps enveloppe plastique (3) et par le fait que les corps enveloppes plastiques (3) sont entourés d'un moule de coulée dont la face intérieure forme les réflecteurs.

6. Emetteur de lumière à effet de surface selon les revendications 1 à 3, caractérisé par le fait que chaque corps semi-conducteur (1) est enrobé dans un corps enveloppe plastique (3) et par le fait que les corps semi-conducteurs (1) sont entourés par un corps de forme (4) dont la face intérieure forme les réflecteurs (6b) et par le fait que de l'air se trouve entre les corps enveloppes plastiques (5) et les corps de forme (4).

7. Emetteur de lumière à effet de surface selon l'une des revendications précédentes, caractérisé par le fait que sur la face supérieure de la structure de rubans conducteurs sont rapportés des réflecteurs supplémentaires (11) qui sont en forme de tronc de parabole et qui, avec les réflecteurs (6a,6b) situés sur la face inférieure de la structure de rubans conducteurs ont la forme d'un paraboloïde.

8. Emetteur de lumière à effet de surface selon la revendication 7, caractérisé par le fait que les réflecteurs supplémentaires (11) placés sur la face supérieure de la structure de rubans conducteurs sont conçus en tant que corps plastiques (3a) dont les surfaces extérieures sont extrêmement réfléchissantes.

9. Emetteur de lumière à effet de surface selon l'une des revendications précédentes, caractérisé par le fait que les corps semi-conducteurs (1) sont mis en circuit en parallèle et/ou l'un derrière l'autre au moyen de la structure de rubans conducteurs (2).

10. Emploi d'un émetteur de lumière à effet de surface selon l'une des revendications précédentes pour des feux de véhicule à moteur, des feux de signalisation ou des feux de gabarit.

11. Procédé de fabrication d'un émetteur de lumière à effet de surface selon l'une des revendications 1 à 9, caractérisé par le fait que les corps semi-conducteurs (1) sont connectés sur une structure de rubans conducteurs (2) autoportante et stabilisée par des liaisons auxiliaires (12) et par le fait que les corps semi-conducteurs (1) sont coulés à l'aide d'un moule de coulée pour former des corps enveloppes (3), par le fait qu'après enlèvement du moule de coulée on revêt des surfaces extérieures des corps enveloppes (3) d'un matériau extrêmement réfléchissant, par le fait qu'ensuite on enlève les liaisons auxiliaires (12) en les coupant et par le fait qu'en cintrant la structure de rubans conducteurs (2b) entre les corps enveloppes on donne à ceux-ci la courbure déterminée désirée.

12. Procédé selon la revendication 11, caractérisé par le fait que l'on revêt d'un matériau extrêmement réfléchissant les surfaces intérieures du moule de coulée, qui possède une courbure déterminée désirée, par le fait que l'on coule les corps semiconducteurs (1) dans ce moule de coulée et par le fait que l'on enlève les liaisons auxiliaires (12) en les coupant.

13. Procédé selon la revendication 11, caractérisé par le fait que l'on enrobe les corps semi-conducteurs (1) d'un matériau plastique, par le fait que l'on revêt d'un matériau extrêmement réfléchissant la surface intérieure d'un corps de forme (4) qui possède une courbure déterminée désirée, par le fait que l'on place sur le corps de forme (4) la structure de rubans conducteurs (2) avec les corps semi-conducteurs (1) et par le fait qu'après avoir découpé les liaisons auxiliaires (12) on colle la structure avec le corps de forme (4).

14. Procédé selon la revendication 11, caractérisé par le fait que l'on rapporte sur la surface supérieure de la structure de rubans conducteurs des corps enveloppes supplémentaires (3a) et que l'on rapporte sur leurs surfaces extérieures un revêtement métallique.
